Europäisches Patentamt

European Patent Office

Office européen des brevets

(11) Publication number: **0 264 105**

**A2**

## (12) EUROPEAN PATENT APPLICATION

(21) Application number: 87114945.6

(22) Date of filing: 13.10.87

(51) Int. Cl.4 **H05K 3/46** , H05K 3/44 , **H05K 1/02**

(30) Priority: 17.10.86 JP 245237/86
10.04.87 JP 86829/87

(43) Date of publication of application:
**20.04.88 Bulletin 88/16**

(84) Designated Contracting States:
**DE FR GB**

(71) Applicant: **HITACHI, LTD.**
**6, Kanda Surugadai 4-chome**
**Chiyoda-ku Tokyo 101(JP)**

(72) Inventor: **Imahashi, Fumio**
**68-6, Nishitawara**
**Hadano-shi(JP)**
Inventor: **Shirasawa, Hisato**
**Hitachi Chishinryo, 24-1**
**Hirasawa Hadano-shi(JP)**
Inventor: **Kawaguchi, Masami**
**Hitachi Chishinryo, 24-1**
**Hirasawa Hadano-shi(JP)**
Inventor: **Sengoku, Norio**
**757-7, Chimura**
**Hadano-shi(JP)**
Inventor: **Imai, Tsutomu**
**11-29, Shincho**
**Hadano-shi(JP)**

(74) Representative: **Patentanwälte Beetz sen. -**
**Beetz jun. Timpe - Siegfried -**
**Schmitt-Fumian**
**Steinsdorfstrasse 10**
**D-8000 München 22(DE)**

(54) Method of producing multilayer printed-wiring board containing metal core.

(57) Disclosed is a method of producing a multilayer printed-wiring board containing at least a metal plate (1) as an inner layer plate. The method comprises the steps of: forming as the metal plate a metal plate having a peripheral portion (3) which is a non-product portion, and a product portion (2) surrounded by the non-product portion, the peripheral portion (3) and the product portion (2) being partially connected; filling an insulating material (10) in non-connecting portions (16) formed between the peripheral portion and the product portion; laminating the metal plate (1) with another inner layer plates to form a multilayer body (20); and separating the peripheral portion from the product portion within the regions (16) in which the insulating material (10) is filled.

**FIG. 2A**

# METHOD OF PRODUCING MULTILAYER PRINTED-WIRING BOARD CONTAINING METAL CORE

## BACKGROUND OF THE INVENTION

The present invention relates to a multilayer printed-wiring board using copper cores as inner conductor layers, and, more particularly, to a method of producing a multilayer printed-wiring board which is suitable for ensuring an insulation at the end surfaces of the board or between its inner conductor layers.

In a known multilayer printed-wiring board containing copper cores, as disclosed in Japanese Patent Application Laid-Open Publication No. 219795/85, it is designed to prevent short-circuiting between any of the inner copper cores and a metal frame of casing in which the multilayer printed-wiring boards are packaged, by means of working, after cutting out the external form of the board, its end surfaces in such a manner that part of the layers of the insulating material protrudes from the end surfaces of the board at at least one location, and then covering the portions of the inner copper cores which are exposed from the end surfaces of the board with the insulating material.

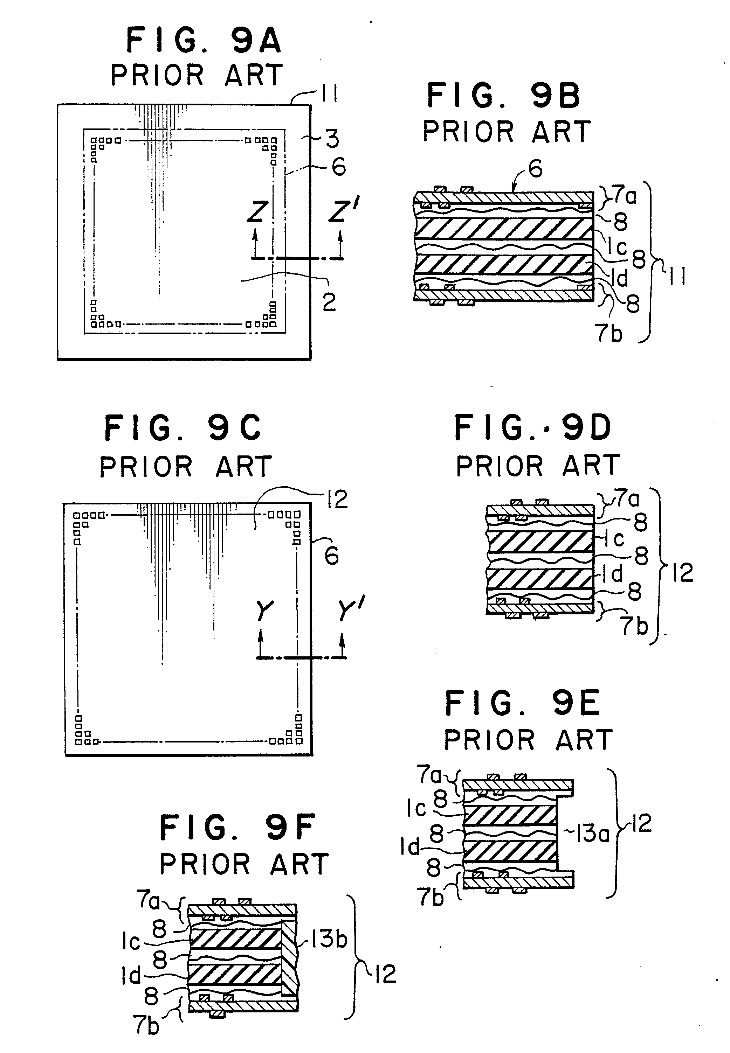

Figs. 9A to 9F show a multilayer printed-wiring board disclosed in Japanese Patent Application Laid-Open Publication No. 219795/85. Fig. 9A shows a board 11 in a state wherein copper cores and layers of insulating material are laminated together. The board 11 has a product portion 2, with a non-product portion 3 surrounding the product portion 2 and monolithically formed with the product portion 2. A two-dot dashed line 6 indicates a line along which the board 11 is to be separated into the product portion 2 and the non-product portion 3. As shown in Fig. 9B, which is a cross-section taken along the line Z - Z' in Fig. 9A, copper cores 1c and 1d and outer layers 7a and 7b are interleaved with prepregs 8 and laminated together to form the board 11. An arrow 6 indicates the position at which the board 11 is cut. Fig. 9c shows a multilayer printed-wiring board 12 after it has been cut, and Fig. 9D is a cross-section taken along the line Y - Y' in Fig. 9C. As can be seen from Fig. 9D, the copper cores 1c and 1d are exposed at the end surfaces of the board 12.

According to the technique disclosed in the aforementioned Laid-Open Publication, as shown in Fig. 9E, a portion 13a at the end surface of the copper cores is worked by a NC milling machine or the like, and thereafter, as shown in Fig. 9F, the portion 13a is coated with an insulating resin 13b to prevent the copper cores from being exposed.

The above-described known technique for manufacturing a multilayer printed-wiring board requires two steps for working the external form, and further requires a step for coating an insulating resin over the side wall portions of the board, thereby increasing the number of manufacturing steps. In addition, the formation of shoulders on the side wall portions is difficult from the viewpoint of accuracy of mechanical working, and such a wall fails to provide sufficient mechanical strength.

The known technique also has a disadvantage in that, if the formed printed-wiring board is of a type which has two or more copper cores located close to each other, the copper cores may form burrs or become sagged when the external form is cut out or when the side surfaces are worked afterwords, thereby short-circuiting the copper cores.

Further, since the known technique generally employs copper cores which have a thickness of 100 $\mu$m to 500 $\mu$m, the resistance to cutting out the external form becomes increased, thereby deteriorating the machinability.

## SUMMARY OF THE INVENTION

Accordingly, an object of the present invention is to provide a method of producing a multilayer printed-wiring board containing as an inner layer plate at least one metal plate which does not allow the inner metal plate to be exposed from the side of the product board when a peripheral portion which is a non-product portion is separated from a product portion surrounded by the peripheral portion after the formation of a multilayer body.

To achieve the above-described object, the present invention provides a method of producing a multilayer printed-wiring board containing as an inner layer plate at least one metal plate, which comprises the steps of: forming a metal plate having a peripheral portion which is a non-product portion, and a product portion surrounded by the peripheral portion, the peripheral portion and the product portion being partially connected; filling an insulating material into non-connecting portions formed between the peripheral portion and the product portion; laminating the metal plate with another inner layer plates to form a multilayer body; and separating the peripheral portion from the product portion within the regions in which the insulating material is filled.

## BRIEF DESCRIPTION OF THE DRAWINGS

Fig. 1A is a plan view of a copper core according to the present invention;

Fig. 1B is a cross-section taken along the line O - O' in Fig. 1A;

Fig. 2A is a plan view of a multilayer body, showing a first embodiment of the present invention;

Fig. 2B is a cross-section taken along the line P - P' in Fig. 2A;

Fig. 3 is a plan view of part of the multilayer body, showing a second embodiment of the present invention;

Fig. 4A is a plan view of a copper core 1a employed in a third embodiment of the present invention;

Fig. 4B is a cross-section taken along the line A - A' in Fig. 4A;

Fig. 4C is a plan view of a copper core 1b employed in the third embodiment;

Fig. 4D is a cross-section taken along the line B - B' in Fig. 4C;

Fig. 4E is a plan view of a multilayer body in the third embodiment;

Fig. 4F is a cross-section taken along the line C - C' in Fig. 4E;

Fig. 5A is a plan view of a multilayer body in which its connecting portions are removed, showing a fourth embodiment of the present invention;

Fig. 5B is a cross-section taken along the line D - D' in Fig. 5A;

Fig. 5C is a plan view of the multilayer body in the fourth embodiment, in which an insulating resin is filled in the connecting portions;

Fig. 5D is a cross-section taken along the line E - E' in Fig. 5C;

Fig. 5E is a plan view of a cut-out multilayer printed-wiring board in the fourth embodiment;

Fig. 5F is a cross-section taken along the line F - F' in Fig. 5E;

Fig. 6A is a plan view of a multilayer body in which the connecting portions are removed, showing a fifth embodiment of the present invention;

Fig. 6B is a plan view of the multilayer body in the fifth embodiment, in which an insulating resin is filled;

Fig. 6C is a cross-section taken along the line G - G' in Fig. 6B;

Fig. 6D is a plan view of a cut-out multilayer printed-wiring board in the fifth embodiment;

Fig. 6E is a cross-section taken along the line H-H' in Fig. 6D;

Fig. 6F is a cross-sectional view of a multilayer body which corresponds to that shown in Fig. 6C, showing a sixth embodiment of the present invention;

Fig. 6G is a cross-sectional view of a multilayer printed-wiring board in the sixth embodiment which corresponds to that shown in Fig. 6E;

Fig. 7 is a perspective view of a multilayer printed-wiring board, showing a seventh embodiment of the present invention;

Fig. 8 is a plan view of a modified embodiment of a copper core; and

Figs. 9A to 9F illustrates a known technique of manufacturing a multilayer printed-wiring board.

## DESCRIPTION OF THE PREFERRED EMBODIMENTS

The present invention will be hereinunder described by way of example with reference to the accompanying drawings.

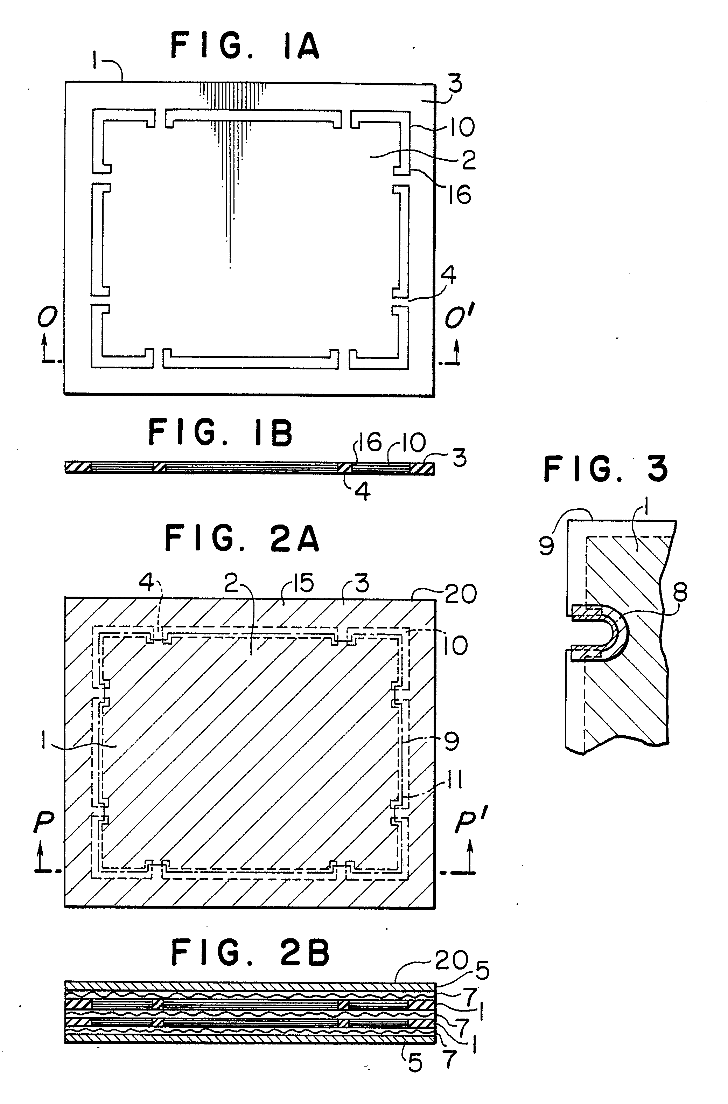

Fig. 1 shows a metal plate to be contained in a multilayer printed-wiring board according to a first embodiment of the present invention. In this embodiment, the metal plate is formed of a copper core 1 which has a thickness of 100 $\mu$m or more. The copper core 1 has: a peripheral, non-product portion 3 wich is to be cut off in a subsequent process; a product portion 2 which is to be used as a product and on which a circuit pattern (for example, clearances between through-holes, which are not shown to simplify the illustration) is formed; connecting portions 4 which connect the product portion 2 and the peripheral portion 3; and slits 16 for separating the product portion 2 from the peripheral portion 3, the slits 16 being filled with an insulating resin.

This copper core 1 is produced in the following way: namely, in order to form the product portion 2, peripheral portion 3, and connecting portions 4, as well as the circuit pattern to be formed within the product portion 2, the upper and lower surfaces of the copper plate are coated with resist film according to the respective shapes of these portions and the circuit pattern. The copper plate is then etched to form each portion and the circuit pattern. Subsequently, an insulating resin 10 is filled into the slits 16 formed by the etching. Fig. 1B is a cross-section taken along the line O - O' in Fig. 1A. As can be seen from the figure, the slits 16 are filled with the insulating resin 10.

The thus-obtained copper cores are stacked to form a multilayer printed-wiring board.

Fig. 2A shows a multilayer body 20 containing the copper cores 1. An hatched region in Fig. 2A corresponds to the copper cores 1. Fig. 2B is a cross-section taken along the line P - P' in Fig. 2A.

The multilayer body 20 is formed of the copper cores 1, prepregs 7 and outer layer plates 5, the copper cores 1 being interleaved with the prepregs 7 and being bonded to the outer layer plates 5 to form the multilayer body 20. the resulting multilayer body comprises a multilayer printed-wiring board 9 constituting the portion of the multilayer body which is located inside a dot dashed line 11, and a carrier frame 15 constituting a portion located outside the dot dashed line 11.

The thus-obtained multilayer body 20 is provided with required through-holes, and then the surface of each of the outer layers is electroless-plated or electroplated to form plated layers thereon. Each of the plated layers is then coated with resist film, and etched to form the desired circuit pattern.

Thereafter, the multilayer printed-wiring board 9 is separated from the carrier frame 15 which is the peripheral portion by cutting the multilayer body 20 along the dot dashed line 11 shown in Fig. 2A by a cutter. In the regions of the slits 16, the cutting along the dot dashed line 11 is carried out in such a manner that part of the insulating resin 10 filling the slits 16 is left on the edges of the multilayer printed-wiring board 9. The regions of the connecting portions 4 are cut along the dot dashed line 11 in such a manner that recesses are formed on the edges of the multilayer printed-wiring board 9.

According to this embodiment a multilayer printed wiring board is obtained in which most of the peripheries of the inner conductor layers are covered with the remaining insulating resin, with the exposed portions of the same being recessed so that the power source layer or ground layer of the multilayer printed-wiring board cannot short-circuit to the frame of the casing into which the multilayer printed-wiring boards are packaged.

A second embodiment of the present invention will be described with reference to Fig. 3. The multilayer printed-wiring board 9 of this embodiment comprises the multilayer printed-wiring board 9 shown in Fig. 2A, with pads 8 formed as the recesses thereof. The pads 8 are electrically connected to the inner copper cores 1, and are therefore formed in such a manner that they do not protrude from the sides of the multilayer printed-wiring board 9.

These pads are formed in the following manner: namely, between the step of fabricating the multilayer body 20 from the copper cores 1, prepregs 7 and outer layer plates 5 and the step of separating the board 9 from the carrier frame 15, each of the connecting portions 4 is cut off by drilling in such a manner that a recess is formed in the multilayer printed-wiring board 9. Each surface of the outer layer plates is then electroless-plated or electroplated in the same manner as in the first embodiment to form plated surfaces which are coated with resist film and etched to form the desired pattern. During this time, each of the recessed portions is provided with an outer layer pad 8 which is large enough for its eventual purpose, but which is formed so that its formation does not make the recess bulge from the multilayer printed-wiring board 9.

Subsequently, the carrier frame 15 is separated by cutting the multilayer body 20 along the dot dashed line 11 by a cutter.

According to this embodiment, since the recessed portion of the multilayer printed-wiring board 9 constitutes the pad connected to the inner copper cores, the recessed portion can be used as power supply groove. Further, since the other peripheral portions of the multilayer printed-wiring board are covered with the insulating resin, short-circuiting of the inner copper cores to the frame of the casing can be prevented.

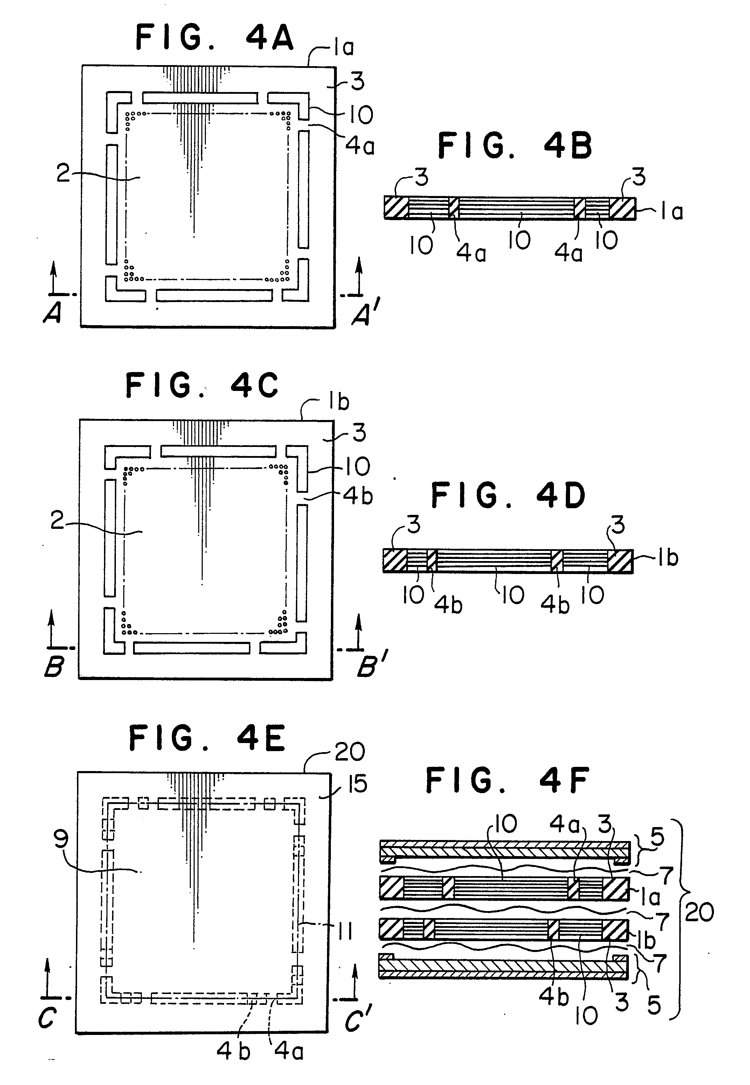

A third embodiment of the present invention will now be described with reference to Figs. 4A to 4F. Figs. 4A and 4C show a copper core 1a and a copper core 1b, respectively. The copper core 1a has connecting portions 4a and the copper core 1b has connecting portions 4b which are not located at positions corresponding to those of the connecting portions 4a, so that the connecting portions 4a and 4b are not aligned when the two copper cores 1a and 1b are stacked. This can be seen more clearly by comparing the cross-sections of the copper cores 1a and 1b.

Figs. 4B and 4D are cross-sections taken along the lines A - A' and B - B' in Figs. 4A and 4C, respectively. As will be seen in these figures, the connecting portions 4a of the copper core 1a are aligned to insulating resin filling the slits of the copper core 1b.

Fig. 4E shows the multilayer body 20 fabricated from the copper cores 1a and 1b, the outer layer plates 5 and the prepregs 7. Fig. 4F is a cross-section taken along the line C - C' in Fig. 4E. The thus-obtained multilayer body 20 is then separated along the dot dashed line 11 shown in Fig. 4E.

The non-alignment of the connecting portions 4a and 4b of the multilayer printed-wiring board 9 in this embodiment can effectively prevent short-circuiting between the inner copper cores or insulation failure which would occur if the coppers in the connecting portions 4a and 4b become sagged or burred when the multilayer printed-wiring board 9 is cut out.

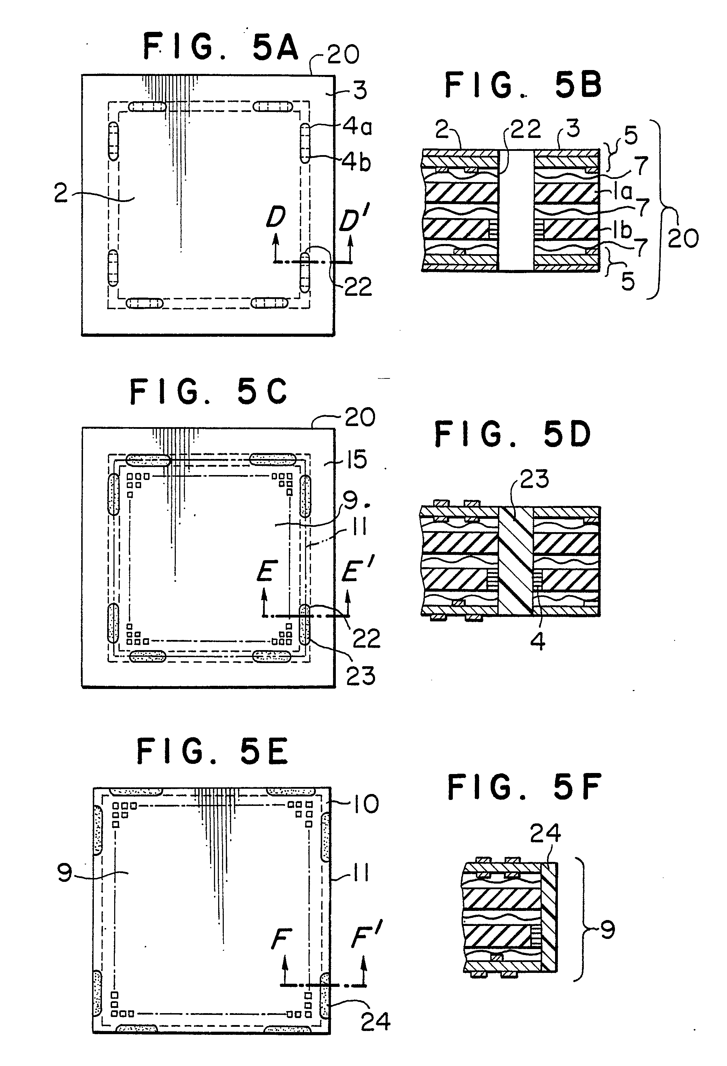

A fourth embodiment of the present invention will now be described with reference to Figs. 5A to 5F. A multilayer printed-wiring board of this embodiment comprises the multilayer body 20 of the third embodiment which is modified so that the connecting portions 4a and 4b are cut off before the external form of the multilayer body 20 is cut out and that insulating resin is filled into the holes formed after the connecting portions 4a and 4b have been removed so that the copper cores are not exposed after the external form of the multilayer body 20 is cut out.

Fig. 5A shows the multilayer body 20 having portions 22 which contain the connecting portions 4a and 4b. The portions 22 are cut by a NC router. Fig. 5B is a cross-section taken along the line D - D' in Fig. 5A, showing the multilayer body 20 in which the portion 22 has been cut off to remove the connecting portion 4a and separate the product portion 2 from the peripheral portion 3.

The empty portions 22 are then filled with insulating resin 23. as shown in Fig. 5C. Fig. 5D is a cross-section taken along the line E - E' in Fig. 5C.

Subsequently. the multilayer printed-wiring board 9 is cut out by cutting the multilayer body 20 along the two-dot dashed line 11 shown in Fig. 5C. During this time. the cutting line passes through each of the empty portions 22. so that the edges of the copper cores 1a and 1b are covered with the remaining portions 24 of the insulating resin 23. Fig. 5E shows the cut-out multilayer printed-wiring board 9. As can be seen from this figure, the entire peripheries of the copper cores 1a and 1b are covered with the insulating resin 10 and 23. Fig. 5F is a cross-section taken along the line F - F' in Fig. 5E.

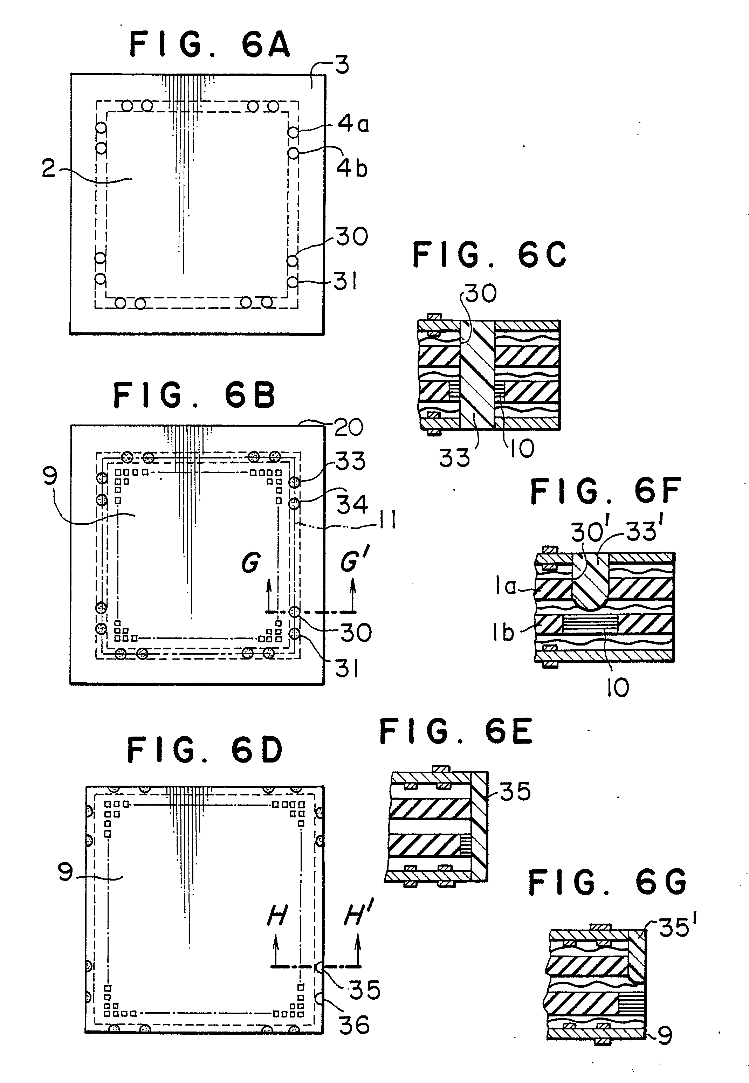

A fifth embodiment of the present invention will now be described with reference to Figs. 6A to 6E. In this embodiment, holes are made in the connecting portions 4a and 4b of the multilayer body 20 by a drill so as to separate the product portions 2 from the peripheral portions 3, and an insulating resin is filled into and set in the connecting portions 4a and 4b before the external form of the multilayer body 20 is cut out.

As shown in Fig. 6A, the connecting portions 4a and 4b are drilled and removed to form holes 30 and 31. Insulating resin 33 and 34 is then filled in the holes 30 and 31, respectively, as shown in Fig.6B. Fig. 6C is a cross-section taken along the line G - G' in Fig. 6B. Finally, the multilayer printed-wiring board 9 is cut out by cutting the multilayer body 20 along the two-dot dashed line 11 shown in Fig. 6B. At this time, since the cutting line passes through the holes 30 and 31, parts 35 and 36 of the insulating resin 33 and 34 filling the holes 30 and 31 remain on the edges of the multilayer printed-wiring board.

A sixth embodiment of the present invention will now be described with reference to Figs. 6F and 6G. A multilayer printed-wiring board of this embodiment has connecting portions 4a and 4b drilled and removed as those of the fifth embodiment. However. the connecting portions 4a and 4b are drilled halfway therethrough, whereas the holes 30 and 31 in the fifth embodiment are through-holes.

Fig. 6F shows a manufacturing process which corresponds to that shown in Fig. 6C. A hole 30' which corresponds to the hole 30 in Fig. 6C is not a through-hole. This is because the hole 30' is drilled for the purpose of removing the connecting portion 4a of the copper core 1a, and this purpose is attained by drilling the connecting portion 4a halfway therethrough. The hole 30' is filled with an insulating resin 33' in the same manner as in the fifth embodiment. As As a result. when the external form of the multilayer body 20 is cut out, part 35' of the insulating resin 33' is left on the sides of the multilayer printed-wiring board 9, as shown in Fig. 6G.

The copper cores of the multilayer printed-wiring board in the third to sixth embodiments are not exposed at the end surfaces thereof. thereby providing insulation of the end surfaces of the multilayer printed-wiring board. Further, since it is not necessary to cut the copper cores when cutting out the external form of the multilayer printed-wiring board, excellent machining is ensured.

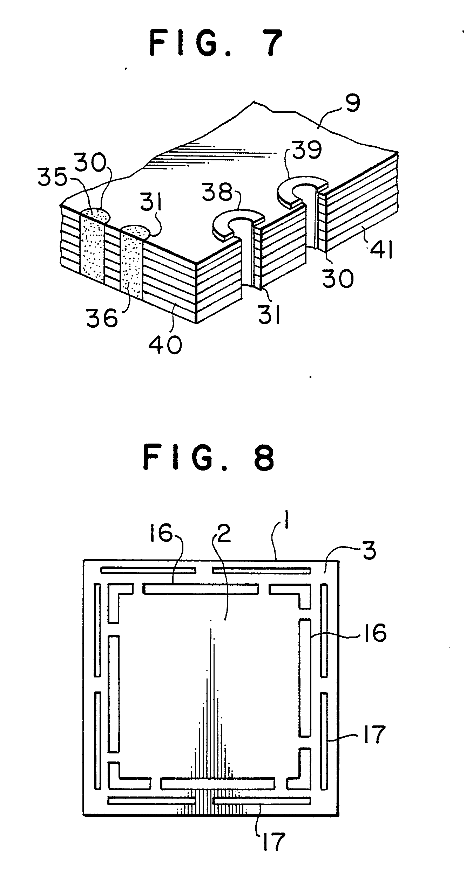

A seventh embodiment of the present invention will now be described with reference to Fig. 7. In this embodiment, part of the holes of the multilayer body 20 which have been drilled according to the fifth or sixth embodiment is provided with pads such as those formed according to the second embodiment. The holes 30 and 31 formed on a side 40 of the multilayer printed-wiring board 9 are filled with the insulating resin according to the fifth embodiment. On the other hand, the holes 30 and 31 formed on a side 41 are provided with pads 38 and 39 according to the second embodiment. Each of the pads 39 is connected to the inner copper core 1a, while each of the pads 38 is connected to the copper core 1b.

Fig. 8 is a plan view of a modified embodiment of the copper core 1. A copper core 1 employed in this embodiment differs from any of the aforementioned copper cores 1, 1a and 1b in that the peripheral portion 3 is provided with slits 17 lying around the slits 16. The distance between the center line of the slits 16 and the center line of the slits 17 is made to be substantially equal to the outer diameter of a cutter used when the external form of the board is cut out. Further, the connecting portions formed between adjacent slits 16 are disposed so as not to align with the connecting portions between the slits 17.

When the copper core formed in the manner shown in Fig. 8, the volume of the copper to be cut when the external form of the multilayer printed-wiring board is cut out by the cutter can be decreased, thereby improving the machinability of the external form. Further. compared in the case in which the insulating resin is filled into the slits 16 alone, both the slits 16 and 17 are separately filled with the insulating resin. This can reduce the area of the slits 16 or 17, and chipping of the resin or generation of voids which may occur when the insulating resin is filled can therefore be prevented. Further, since the connecting portions of the slits 16 and those of the slits 17 are not aligned, short-circuiting between the inner copper cores or insulation failure which would occur if the copper cores become sagged when the external form is cut out can be prevented. The copper core of this embodiment can be employed in the multilayer printed-wiring board in either of the first to seventh embodiments.

In the multilayer printed-wiring board of this invention, since each of the hard copper cores is already separated into product portion and non-product portion except for the connecting portions before they are stacked into a multilayer body, the working for cutting the product portion from the multilayer body is facilitated.

Insulating material is filled between the product portion and the peripheral portion of the copper cores when they are stacked into a multilayer body. Therefore, a multilayer printed-wiring board which has an insulating layer at the periphery thereof is provided by simply cutting out the product portions.

If the connecting portions are drilled or grooved after the multilayer body has been formed and the insulating resin is filled and set in the drilled or grooved portions before the external form is cut out, the edges of the copper cores can be entirely covered by the insulating resin after cutting out the external form.

If the connecting portions are recessed inwardly when the external form of the multilayer body with the drilled connecting portions is cut out or when the external form of the multilayer body is cut out, the resultant multilayer printed-wiring board can be prevented from coming into contact with the frame of the casing when the former is packaged in the latter, although complete insulation therebetween is not provided.

Furthermore, in the case in which two inner copper cores are contained in the multilayer body, if the connecting portions are formed in such a manner that those in one of the copper cores are not aligned with those in the other copper core, short-circuiting between the copper cores or insulation failure due to the burr or sagging of the coppers can be prevented.

Still furthermore, if the connecting portions are removed before the external form is cut out and the insulating material is filled in the removed connecting portions, it is not necessary to cut the copper cores when the external form is cut out, thereby making it possible to effect a good machining.

## Claims

1. A method of producing a multilayer printed-wiring board containing at least one metal plate as an inner layer plate, comprising the steps of:
forming as said metal plate a metal plate having a peripheral portion which is a non-product portion, and a product portion surrounded by said non-product portion, said peripherical portion and said product portion being partially connected;
filling an insulating material in non-connecting portions formed between said peripheral portion and said product portion;
laminating said metal plate with another inner layer plates to form a multilayer body; and
separating said peripheral portion form said product portion within the regions in which said insulating material is filled.

2. A method of producing a multilayer printed-wiring board according to claim 1, wherein said metal plate is monolithically formed to have said peripheral portion, said product portion and said connecting portions.

3. A method of producing a multilayer printed-wiring board according to claim 1, wherein in said separating step said connecting portions are cut away in such a manner that a cutting line is recessed inwardly toward said product portion side from the separated surface.

4. A method of producing a multilayer printed-wiring board according to claim 1, wherein it contains two or more of said metal plates having the same shape.

5. A method of producing a multilayer printed-wiring board containing at least one metal plate as an inner layer plate, comprising the steps of:
forming as said metal plate a metal plate having a peripheral portion which is a non-product portion, and a product portion surrounded by said peripheral portion, said peripheral portion and said product portion being partially connected;
filling an insulating material is non-connecting portions formed between said peripheral portion and said product portion;
laminating two or more of said metal plates to form a multilayer body, said metal plates having mutually non-aligned connecting portions; and
separating said peripheral portions from said product portions within the regions in which said insulating material is filled.

6. A method of producing a multilayer printed-wiring board according to claim 5, wherein said metal plate is monolithically formed to have said peripheral portion, said product portion and said connecting portions.

7. A method of producing a multilayer printed-wiring board containing at least one metal plate as an inner layer plate, comprising the steps of:

forming as said metal plate a metal plate having a peripheral portion which is a non-product portion, and a product portion surrounded by said peripheral portion, said peripheral portion and said product portion being partially connected;

filling an insulation material in non-connecting portions formed between said peripheral portion and said product portion:

laminating two or more of said metal plates to form a multilayer body, said metal plates having mutually non-aligned connecting portions:

separating said connecting portions and filling an insulating material in separated portions; and

separating said peripheral portions from said product portions within the regions in which said insulating material is filled.

8. A metal plate to be disposed as an inner layer plate of a multilayer printed-wiring board characterized in that it is formed such that a peripheral portion which is a non-product portion and a product portion surrounded by said peripheral portion are partially connected.

FIG. IA

FIG. IB

FIG. 2A

FIG. 2B

FIG. 3

FIG. 4A

FIG. 4B

FIG. 4C

FIG. 4D

FIG. 4E

FIG. 4F

# FIG. 5A

20
3
4a
4b
2
D  D'
22

# FIG. 5B

2  22  3  5
7
1a
7
1b
7
5
20

# FIG. 5C

20
15
9
11
E  E'
22
23

# FIG. 5D

23
4

# FIG. 5E

10
9
11
F  F'
24

# FIG. 5F

24
9

# FIG. 6A

3
4a
4b
30
31
2

# FIG. 6B

20
33
34
11
G    G'
30
31
9

# FIG. 6C

30
33    10

# FIG. 6F

30'   33'
1a
1b
10

# FIG. 6D

9
H    H'
35
36

# FIG. 6E

35

# FIG. 6G

35'
9

# FIG. 7

# FIG. 8

# FIG. 9A
## PRIOR ART

# FIG. 9B
## PRIOR ART

# FIG. 9C
## PRIOR ART

# FIG. 9D
## PRIOR ART

# FIG. 9E
## PRIOR ART

# FIG. 9F
## PRIOR ART